# EUROPEAN PATENT APPLICATION

(11) **EP 1 353 224 A1**
(43) Date of publication of application: **15.10.2003**
(21) Application number: 03252304.5
(22) Date of filing: 11.04.2003
(51) Int. Cl.: G03F 1/14, G03F 7/20, G03F 1/00

(54) **Cleaning of a pellicle-mask assembly**

(30) Priority: 12.04.2002 JP 2002111261
(71) Applicant: Dai Nippon Printing Co., Ltd., Tokyo-to, 162-8001 (JP)
(72) Inventor: Koizumi, Yasuhiro, c/o Dai Nippon Printing Co. Ltd, Shinjuku-ku, Tokyo-to, 162-8001 (JP); Tsuchiya, Katsuhide, Dai Nippon Printing Co., Ltd., Shinjuku-ku, Tokyo-to, 162-8001 (JP)
(74) Representative: Geary, Stephen

(57) **Abstract**

A main objective of the present invention is to provide a method of making a foreign matter harmless which can make the foreign matter, after attaching a pellicle, existing on a transmitting region of a reticle with a pellicle harmless, under pellicle attached condition. For attaining the above-described objective, the present invention provides a method of making a foreign matter harmless wherein a foreign matter existing on a transmitting region of a reticle with a pellicle is irradiated with laser, via the pellicle membrane to make the foreign matter harmless.

## Description

The present invention relates to a method of making a foreign matter harmless which enables making a foreign matter harmless existing inside a reticle with a pellicle, without peeling off the pellicle.

Conventionally, as a method of forming a fine circuit pattern for manufacturing of semiconductors and liquid crystals, there is known a method of realizing a fine electron circuit of a semiconductor and the like by optically printing a circuit master drawing called photomask or reticle onto a wafer using a light transfer apparatus such as a stepper and the like. A reticle used as such a master drawing for transfer of a fine pattern onto a wafer is a base of an electron circuit pattern, therefore, it is required that such a pattern has no defect and has high precision.

For example, adhesion of a foreign matter to an exposure transmitting region of a reticle makes a shadow by exposure in conducting a transfer process, causing a serious abnormality on a circuit such as breaking and/or bridging. As a countermeasure against such problems, pollution by adhesion of a foreign matter is prevented by attaching a dust-proof part, so-called pellicle.

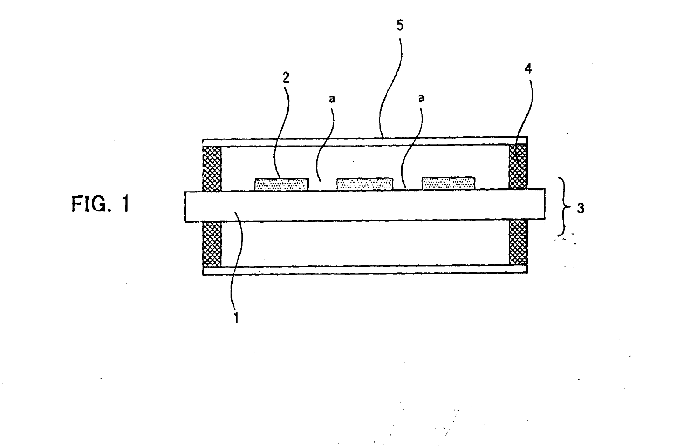

FIG. 1 is a schematic sectional view of such a reticle with a pellicle . Specifically explained on this FIG. 1, pellicle membranes 5 suitably fixed by pellicle frames 4 are connected, for example adhered with an adhesive material, to a substrate 1 so as to sandwich a reticle 3 composed of a substrate 1 on which shading layers 2 are formed in a pattern. Thus, invasion of a foreign matter and the like into the interior is prevented by sealing the reticle with pellicles.

However, a problem arises after attaching such pellicles, in some cases that foreign matters exist on a transmitting region of the reticle with pellicles due to an organic material crystallized by the change of inside pressure, migration of foreign matters adhered on the pellicle frame and reticle surface, and the like. For treating such foreign matters exist on a transmitting region after attaching pellicles, a treatment is necessary which a pellicle attached is once peeled off and foreign matters are removed, then, the pellicle is attached again. However, such a treatment needs a lot of jobs that is, it may be complicated costly and labour intensive because repetition of detaching and attaching of pellicles may, further, causes damage of a reticle, and the like.

The present invention has been accomplished in view of the above-described problems, and a main objective is to provide a method of making a foreign matter harmless which can make the foreign matter existing on a transmitting region of a reticle with a pellicle harmless, under pellicle attached condition, that is without the need to remove the pellicle, after attaching a pellicle.

The first aspect of the present invention provides a method of making a foreign matter harmless, wherein a foreign matter existing on a transmitting region of a reticle with a pellicle is irradiated with laser, via the pellicle membrane, to make the foreign matter harmless.

According to the first aspect, the present invention thus makes a foreign matter harmless by irradiating a foreign matter existing on a transmitting region of the reticle, with laser under condition of the pellicle attached to the reticle, after attaching a pellicle to a reticle. Therefore, there is no need to conduct treatments such as detaching and re-attaching of the pellicle in treating a foreign matter generated in the reticle with pellicle, so that the reticle manufacturing efficiency can be improved significantly.

In the present invention, the method of making a foreign matter harmless can be a method which decomposes or sublimates substances constituting the foreign matter into a size which is not transferred on the wafer. By decomposing or sublimating a foreign matter existing on a transmitting region of a reticle into materials of size not transferred on the wafer, it is possible to avoid transfer of unsuitable patterns due to a shadow of the foreign matter onto a wafer when the patterns are optically transferred onto a wafer and the like by using a reticle, and a reticle which an influence of the foreign matter is suppressed to the minimum level can be provided.

In the present invention, the method of making a foreign matter harmless can be a method which moves the foreign matter out of the transmitting region by laser. By conducting treatments such as moving a foreign matter out of a transmitting region, then, fixing the material, and the like, it is prevented to transfer a shade of the foreign matter onto a wafer, when the patterns of the reticle are transferred onto a wafer.

In the second aspect of the present invention, there is provided a method for manufacturing a reticle, comprising a process of making a foreign matter harmless using the method of making a foreign matter harmless according to the first aspect.

According to the second aspect, by adding the process of making a foreign matter harmless of the present invention to the method for manufacturing the reticle, it is possible to prevent invasion of a foreign matter from outside, further, it is possible to produce a reticle capable of suppressing an influence of a foreign matter generated inside to the minimum level.

The present invention makes a foreign matter harmless by, after attaching a pellicle to a reticle, irradiating a foreign matter existing on a transmitting region of the reticle with laser under condition of the pellicle attached to the reticle, therefore, there is no need to conduct treatments such as detaching and re-attaching of the pellicle in treating a foreign matter generated in the reticle with pellicle, so that the reticle manufacturing efficiency can be improved significantly.

The invention further provides a method for manufacturing a reticle having a transmitting region, a pellicle being connected to the reticle and foreign matter on the transmitting region, which comprises irradiating the foreign matter with a laser through the pellicle such that the foreign matter does not create a shadow during use of the reticle in a light transfer process.

In another aspect, the invention provides for use of a reticle produced by a method for manufacturing a reticle according to the present invention in a light transfer process for producing a pattern on a wafer.

The invention further provides a method for manufacturing a semiconductor or liquid crystal having a circuit pattern on a wafer in which the pattern is formed on the wafer by a light transfer process comprising irradiating a reticle produced by a method for manufacturing a reticle according to the present invention so as to create the pattern on the wafer.

FIG. 1 is a schematic sectional view of a reticle with a pellicle .

The method of making a foreign matter harmless of the present invention is such that a foreign matter existing on a transmitting region of a reticle with a pellicle is irradiated with laser, via the pellicle membrane to make the foreign matter harmless.

Here, the transmitting region of a reticle indicates a region on which a shading layer is not formed and transmits light in transferring patterns onto a wafer using a reticle.

The present invention has a feature that after attaching a pellicle, a foreign matter existing on a transmitting region of a reticle is made harmless under pellicle attached condition. Therefore, a foreign matter can be made harmless under pellicle attached condition in the present invention while conventionally, it is impossible to avoid disposing a reticle or jobs are necessary such as detaching a pellicle and treating the foreign matter, then, re-attaching a pellicle, so that it is possible to increase yield and improve manufacturing efficiency in manufacturing a reticle with a pellicle.

To make a foreign matter harmless in the present invention, is to treat a foreign matter to give a condition that a shade of a foreign matter is not recognized by a light transfer apparatus such as a stepper and the like,and unsuitable patterns are not transferred onto a wafer ,in transferring pattern onto a wafer and the like by using a reticle with a pellicle. Therefore,for method of making the foreign matter to give such a harmless condition ,it is not particularly restricted ,as long as the foreign matter is treated to give a condition that the shade of a foreign matter is not transferred in transferring. Specifically, there are methods that substances constituting a foreign matter are decomposed or sublimated to be the size not being transferred on the wafer, or a foreign matter is moved onto a shading layer, and the like.

In the present invention, for method enabling the above method of making the foreign matter harmless is to irradiate a foreign matter existing on a pattern transmitting region on a reticle with laser via a pellicle membrane. For a basic embodiment, the laser having a wavelength in the range of 350 nm to 550 nm is suitably used.

Such specific methods of making a foreign matter harmless by using laser, that is, making the foreign matter harmless by decomposition or sublimation, and by moving as described above will be explained below.

### (1) Making a foreign matter harmless by decomposition or sublimation

As a first embodiment of the method of making a foreign matter harmless, there is a method of making a foreign matter harmless in which substances constituting the foreign matter are decomposed or sublimated to be the size not being transferred on the wafer. As the laser used for enabling making a foreign matter harmless , it is necessary to use laser having wavelength which acts on the foreign matter. The foreign matter to be made harmless is not particularly restricted, but the foreign matter is generally organic foreign matter.

Specifically, by using laser having wavelength absorbed by a foreign matter, it is possible to heat a foreign matter in irradiating the foreign matter with laser, and by this, the foreign matter can be decomposed or sublimated to be made harmless. Further, for example, by using laser having wavelength which acts directly on a molecular chain of molecules constituting a foreign matter, the foreign matter is decomposed to be made harmless.

As a typical example, of a foreign matter to be made harmless by such methods, are residues of photoresists used in mask manufacturing. Particularly, residues of photoresist which have a novolak resin and quinonediazide, a novolak resin and polymethylpentene-1-sulfone, chloromethylated polystyrene and the like as main components, and residue of chemical amplification-type resists obtained by mixing a novolak resin or phenol resin with an inhibitor, acid generator and the like are the typical examples. In such photoresist residues, energy absorption occurs by 10 to 20% at a laser wavelength of 350 nm and by about 50% at a laser wavelength of 500 nm, so that a foreign matter is decomposed or sublimated. As the laser wavelength used here, those in the range from 350 nm to 550 nm are preferably used, and a foreign matter can be made harmless without problems since by making focal length of the object lens of a laser repair systems longer to avoid focusing on a pellicle membrane so that energy density is low and the pellicle is not damaged.

### (2) Making a foreign matter harmless by movement

Next, as a second embodiment of making a foreign matter harmless, a method of moving a foreign matter out of a transmitting region by laser will be explained below.

In this case, a foreign matter is moved out of a transmitting region, and generally, it is preferable that, subsequently, the foreign matter is fixed at the moved position. When the foreign matter is in the form of block or is very light, there is a case which by absorbing laser energy in moving by impact of laser, it is fused and fixed on a place having low temperature such as chromium and the like, after moving.

The kind of laser used in such a method of moving a foreign matter to make harmless, is not particularly restricted in laser wavelength, and the like.

Further, the foreign matter made harmless by this method is not particularly restricted, but the foreign matter is generally inorganic foreign matter.

### (Method for manufacturing reticle)

In the present invention, when the presence of a foreign matter is recognized in a transmitting region of a reticle after attaching of a reticle after manufacturing of a reticle with a pellicle by a known manufacturing method, a reticle with a pellicle which the foreign matter is made harmless can be manufactured by conducting a process of making the foreign matter harmless by the method of making a foreign matter harmless in the present invention as described above.

By conducting the process of making the foreign matter harmless of the present invention, the manufacturing process can be simplified significantly and the manufacturing efficiency can be improved, since it is not necessity to detach and re-attach a pellicle conventionally conducted.

Explanations of other processes in the method for manufacturing reticle of the present invention are omitted here, since various methods conventionally conducted can be used in combination and are known to the skilled person.

The present invention is not limited to the above-described embodiments. The above-described embodiments are only examples, and those having substantially the same constitution and performing the same action and effect as the technological ideas described in the claims of the present invention are anyway included in the technological range of the present invention.

## Claims

1. A method of making a foreign matter harmless, wherein a foreign matter existing on a transmitting region of a reticle with a pellicle is irradiated with laser, via the pellicle membrane to make the foreign matter harmless.

2. A method of making a foreign matter harmless according to claim 1, wherein the foreign matter is made harmless by decomposing or sublimating substances constituting the foreign matter by laser into a size which is not transferred on a wafer.

3. A method of making a foreign matter harmless according to claim 1, wherein the foreign matter is made harmless by moving the foreign matter out of the transmitting region by laser.

4. A method according to any one of claims 1 to 3 wherein the laser has a wavelength of 350 to 550nm.

5. A method according to any one of claims 1 to 4 wherein the foreign matter is a residue of a photoresist.

6. A method for manufacturing a reticle, comprising a process of making a foreign matter harmless by a method according to any one of claims 1 to 5.

7. A method for manufacturing a reticle having a transmitting region, a pellicle being connected to the reticle and foreign matter on the transmitting region, which comprises irradiating the foreign matter with a laser through the pellicle such that the foreign matter does not create a shadow during use of the reticle in a light transfer process.

8. Use of a reticle produced by a method according to claim 6 or claim 7 in a light transfer process for producing a pattern on a wafer.

9. A method for manufacturing a semiconductor or liquid crystal having a circuit pattern on a wafer in which the pattern is formed on the wafer by a light transfer process comprising irradiating a reticle produced by a method according to claim 6 or claim 7 so as to create the pattern on the wafer.
